## Europäisches Patentamt
## European Patent Office
## Office européen des brevets

(19)

(11) Publication number: **0 196 838**
**A2**

(12) # EUROPEAN PATENT APPLICATION

(21) Application number: **86302100.2**

(22) Date of filing: **21.03.86**

(51) Int. Cl.⁴: **G 06 F 15/74**

(30) Priority: **25.03.85 US 715846**

(43) Date of publication of application:
**08.10.86 Bulletin 86/41**

(84) Designated Contracting States:
**AT CH DE FR GB IT LI NL**

(71) Applicant: **WESTINGHOUSE ELECTRIC CORPORATION**
**Westinghouse Building Gateway Center**
**Pittsburgh Pennsylvania 15235(US)**

(72) Inventor: **Maxwell, Albert, Jr.**
**6801 Justice Drive**
**Raleigh North Carolina 27609(US)**

(72) Inventor: **January, Garry Lee**
**1104 Tree Top Court**
**Raleigh North Carolina 27612(US)**

(72) Inventor: **Shepherd, Dennis Arnold**
**804 Van Thomas Drive**
**Raleigh North Carolina 27609(US)**

(74) Representative: **van Berlyn, Ronald Gilbert**
**23, Centre Heights**
**London, NW3 6JG(GB)**

(54) **Mass data recorder with dual memory system.**

(57) A mass data acquisition system utilizes a recorder that is provided with both CMOS RAM (18) and a removable memory cartridge (28). The memory cartridge can be used to transport data from the recorder to a translator (32). Furthermore, the CMOS RAM is used to store the data records formulated during an entire recording period. When operated in the RAM mode (28-out), all data is stored in the CMOS RAM and the data cartridge is used only for purposes of transporting data to the translator. When operated in the cartridge mode (28-inserted), all formulated data is stored in both the CMOS RAM and the cartridge. This cartridge mode of operation provides redundancy and serves as a backup dual memory system to prevent loss of data in the event that a memory malfunction occurs in either one of the two memory media. The recorder can also communicate with a translator (32) over phone lines (38) in conjunction with serial I/O (34) and a MODEM (36). When communicating with a translator on the phone line, data can be obtained from either a cartridge, when in the cartridge mode, or directly from CMOS RAM when in the RAM mode.

./...

1

# MASS DATA RECORDER WITH DUAL MEMORY SYSTEM

The present invention relates generally to mass data acquisition systems and, more particularly, to a data recorder with a dual memory system comprising both random access memory and a removable solid state memory cartridge.

Electric utilities use mass data acquisition systems to monitor an electric consumer's energy usage over a preselected period of time. These devices are alternatively known as data recorders, demand recorders, load survey recorders and mass data acquisition systems.

The most common type of mass data acquisition system utilize a tape recorder, and in another type a recorder having a tape cartridge is used with an electric load research device including an enclosure having adjustable meter positions as in U.S. Patents 4,063,661 and 4,115,835 issued to Doby on December 20, 1977 and September 19, 1978, respectively. Providing a battery powered recorder is known and there are various known types of outage indicating apparatus for meter telemetry systems including data recorders.

When tape recorders are used for the purposes of storing data for a mass data acquisition system, the magnetic tape is later read by a translator and the electric consumer's demand profile is analyzed. Many different types of translators are known to those skilled in the art including reverse direction tape translation. A translator for processing meter telemetry recordings containing power

0196838

loss pulses is disclosed in U.S. Patent No. 4,065,793, which issued to Maxwell on December 27, 1974.

Mass data acquisition systems used by electrical utilities receive information from electrical meters and record that information as historical data records for later analysis. Typically, pulse initiators are used to provide signals from the meters to the mass data acquisition system which represent predetermined quantities of electrical energy consumption. Magnetodiode pulse initiator have been used for these purposes, and various solid state radiometric pulse initiator for remote meter reading systems have also been developed.

Recent innovations in the field of mass data acquisition systems have incorporated solid state memory devices as a data storage medium instead of magnetic tape cartridges. These solid state memory cartridges contain either bubble memory or electrically erasable programmable read only memory (EEPROM). Various types of memory cartridges are commercially available and are well known to those skilled in the art. For example a bubble memory cartridge such as type FBM43CB is available in commercial quantities from Fujitsu America, Inc.

Another way of transmitting information between a mass data acquisition system recorder and a translator is to provide signal communication directly between the recorder and the translator. This is accomplished by using a modulator/demodulator (MODEM) for purposes of connecting both recorder and the translator to a telephone line system. In this type of mass data acquisition system, the translator communicates directly with the recorder for the purpose of requesting a data transfer. The recorder then responds by sending its stored information, on the telephone line, to the translator for purposes of analysis and report generation.

With these types of alternative systems available, different types of mass data acquisition systems have been designed and utilized by electric utilities. One type of system employs a tape recorder that receives a removable tape cartridge. At the end of a recording period, which could typically be a month in length, the tape cartridge is removed and physically transported to a translator that is designed to receive the tape cartridge and read its contents. At the time when the tape cartridge is removed from the recorder, a new tape cartridge is loaded into the recorder for purposes of continuing the data recording process.

If a telephone system is used, the stored data is transmitted on the phone lines between the recorder and the translator. A telephone system can be used in conjunction with a removable memory medium such as a magnetic tape cartridge or bubble memory cartridge. This is done to prevent loss of data that could otherwise be caused by telephone line problems. A more typical system would incorporate a telephone system in conjunction with battery backed-up RAM for data storage.

When bubble memory cartridges or EEPROM cartridges are used, they essentially provide a solid state replacement for the magnetic tape cartridge. Although a different memory medium is used, the general procedure is essentially the same as if a magnetic tape cartridge was used. At the end of a recording period, the solid state memory cartridge is removed from the recorder and transported physically to a translator that is designed to receive the solid state memory cartridge and analyze its contents. In these types of systems, a new solid state memory cartridge is inserted into the recorder immediately after removal of the existing memory cartridge.

Existing mass data acquisition systems, as described above, present serious disadvantages for both the electric utility and the electrical consumer. For example, if magnetic tape cartridges are used each recorder must be provided with at least two tape cartridges. One tape cartridge would be inserted into the recorder when an associated tape cartridge is being transported to the translator. This disadvantage requires a plurality of memory devices that is greater in number than the number of recorders. This same disadvantage exists when bubble memory cartridges or EEPROM memory cartridges are used. Since data is being produced during the transportation and translation procedures, a duplicate memory cartridge must be in place in the recorder while an associated memory cartridge is being transported to a translator and analyzed. The requirement for duplicate memory cartridges in numbers that exceed the actual number of recorders presents an extra expense for either the electric utility or the consumer.

The use of telephone communication between the recorder and the translator, itself, can introduce problems for the electric utility. Occasional telephone line problems present a potential obstacle to the transfer of data from the recorder to the translator. Furthermore, in many cases a dedicated phone line must be provided for each recorder in order to assure available access when information is requested by the translator. These dedicated phone lines increase the expense of the data acquisition system.

The chief object of the present invention is to provide a data recorder in a mass data acquisition system that overcomes the above problems and facilitates multiple mode functioning for the efficient passing of data, while preventing the loss of data that would otherwise be caused by memory fault or other fault conditions.

With this object in view, the invention resides in a data recorder, comprising: means for receiving a first signal representative of a predetermined quantity of a measured parameter such as electrical energy consumption; means for providing a second signal representative of the passage of a predetermined period of time; means for formulating a record of said measured parameter as a function of time, said formulating means being configured to sum a plurality of said first signals over a preselected length of time measured as a function of said second signal; first memory means for storing a plurality of said records, said first memory means being connected in signal communication with said formulating means; means, connected in signal communication with said formulating means, for connecting a removable second memory means in signal communication with said formulating means; and means for transmitting messages to a remote device, said transmitting means being connected in signal communication with said formulating device.

The invention further resides in a a mass data acquisition system, comprising: first receiving means for providing a first signal representing measured data; means for providing timing pulses, each of said timing pulses representing a predetermined length of time; means, connected in signal communication with both said first receiving and said providing means, for formulating data records; first memory means for storing a plurality of said data records, said first memory means being connected in signal communication with said formulating means; second means, connected in signal communication with said formulating means, for receiving a removable second memory means for storing said plurality of data records; and means for detecting the presence of said removable second memory means connected in signal communication with said second receiving means, said formulating means being responsive to said detecting means, said formulating means being configured to store said data records in said first memory means when said detecting means determines the absence of said removable second memory means and to store said data records in both said first memory means and said removable second memory means when said detecting means determines the presence of said removable second memory means.

The present invention will be more readily apparent from the following exemplary description, taken in conjunction with the accompanying drawing, in which:

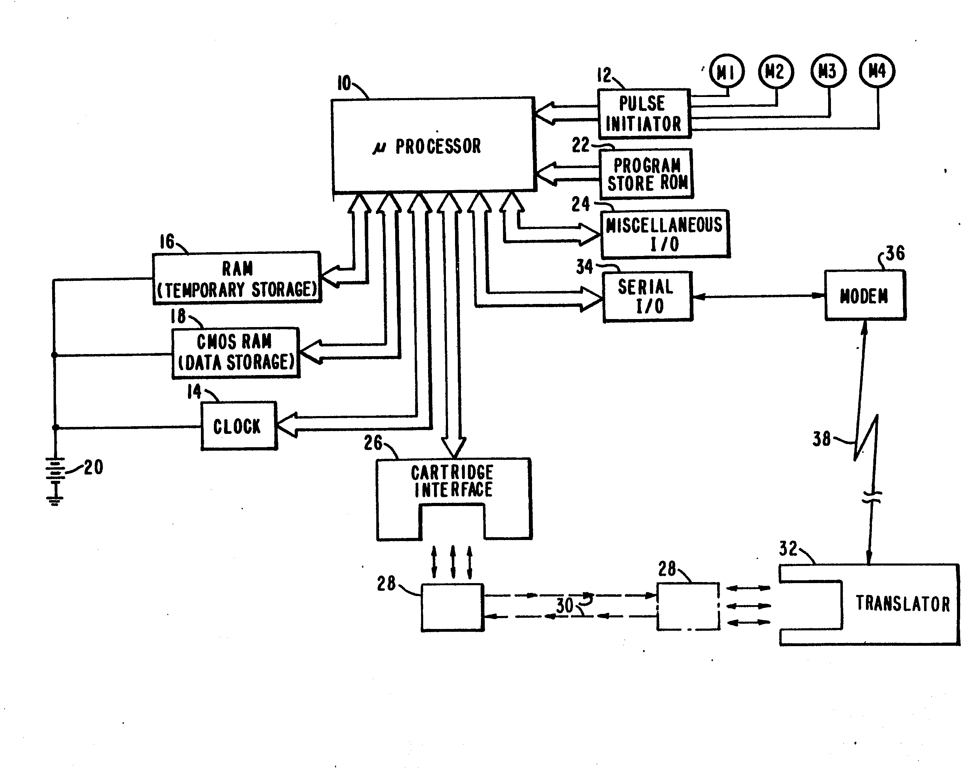

Figure 1 illustrates a schematic diagram of the present invention.

The present disclosure reveals a mass data acquisition system that avoids the disadvantages that presently exist in known recorder systems. It utilizes random access memory (RAM) for the storage of data within the mass data acquisition system. The RAM is of a sufficient size to store the required data records for an entire recording period. It further utilizes a removable memory medium, such as an EEPROM cartridge. Furthermore, the mass data acquisition system of the present invention is provided with a modulator/demodulator (MODEM) that permits it to be connected to a telephone system for purposes of directly communicating with a remote translator. This mass data acquisition system can store an entire recording period's data in RAM and/or in a removable memory cartridge and can also communicate directly with a translator on the telephone lines. The RAM can be utilized without the presence of a removable EEPROM cartridge during periods when the cartridge is being transported to a remote translator for purposes of analysis and report generation. When a memory cartridge is in place in the present invention, all data records are simultaneously stored in both RAM and the cartridge. This provides a backup system that can prevent loss of data due to a malfunction in either the RAM or the removable cartridge. Furthermore, when a telephone request is received from a translator two alternative sources of data are provided which are identical and provide alternatives if one of the memory storage media exhibit a fault condition.

Operation may be performed in either a "RAM mode" or a "cartridge mode". When in the RAM mode, the mass data acquisition system stores its formulated data records only in RAM. This mode is used when a memory cartridge is not present and available for use. To provide a signal representing the presence of a cartridge, a circuit is provided that is completed by the connector of the cartridge. This signal, when completed, informs the recorder that a cartridge is in place to receive data. The alternative mode, referred to herein as the cartridge mode, is used the presence of a removable memory cartridge is detected. When in the cartridge mode, formulated data records is stored in both RAM and the removable cartridge. Therefore, the cartridge mode provides a backup system in case either RAM or the cartridge exhibits a fault condition. This prevents loss of data.

When a telephone request is received from the translator, it first determines the present mode and acts accordingly. If it is in the cartridge mode, the data history for the electric energy consumer is obtained directly from the cartridge and transmitted over the telephone line to the translator. If it is in the RAM mode, the historical data records are obtained from RAM and transmitted to the translator on the phone lines.

The overall cost of the mass data acquisition system is reduced by the features described herein. If the utility wishes to remove the removable memory cartridge from the recorder and physically transport it to the translator for analysis, no new memory cartridge has to be inserted into the recorder. During the time when the removable memory cartridge is absent from the recorder, it reverts to the RAM mode and stores all data records in RAM. At a later time, when the memory cartridge is returned to its position in the recorder, the stored information in the RAM is transferred to the removable memory cartridge. For example, if the recording period is one month long and it takes three days to remove the memory cartridge and transport it to the translator for analysis, it would revert to the RAM mode during the three day period when the cartridge was absent. When the cartridge is again placed in the present invention, at the end of three days, it would automatically place itself in the cartridge mode and the data that was stored in RAM during the three day period of time would be automatically transferred to the cartridge. Beginning at the time when the cartridge was replaced, all later data would be stored simultaneously in both RAM and the memory cartridge. It should be understood that the use of a cartridge is not a requirement for all mass data acquisition systems. Some known systems require a hand-held portable reader that is provided with a microprocessor and large memory capacity. The portable reader is used to retrieve the stored data when the telephone system is inoperable or, in some cases, not included as part of the mass data acquisition system.

Figure 1 illustrates a block diagram of the present invention. A mass data acquisition system made in accordance with the present invention utilizes a microprocessor 10 which provides a means for formulating a record of a measured parameter, such as electrical energy consumption. The microprocessor 10 used in a preferred embodiment of the present invention is type MC6809 which is available in commercial quantities from the Motorola Corporation.

The microprocessor 10 is connected in signal communication with a source of pulse inputs, such as a pulse initiator 12. The pulse initiator 12 is connected to one or more meters (e.g. M1-M4) which measure energy consumption. The pulse initiator 12 provides a signal to the microprocessor 10 in which each signal pulse represents a predetermined amount of consumed electrical energy. The microprocessor 10 receives the pulses during a preselected period of time, such as a fifteen minute interval, and formulates a data record that represents the historical consumption for that length of time.

The mass data acquisition system of the present invention also utilizes a clock 14 which provides a plurality of timing pulses wherein each pulse represents the passage of a preselected length of time. For example, in a typical embodiment of the present invention, with a type of clock μPD1990 each pulse from the clock 14 would be a 60th of a second. The microprocessor 10 would accumulate the pulses from the clock 14 to measure the passage of a predetermined period of time and formulate a record of electrical energy consumption by counting the number of

0196838

pulses received from the pulse initiator 12 during that period. The microprocessor also utilizes the timing pulses to maintain an internal calendar and read time system in memory (i.e. RAM 16). This permits the microprocessor to store the time and date along with the recorded consumption data for later use by the utility in comparing the consumer's consumption history to that of the entire power distribution system. The period of time associated with one data record would typically be 15 minutes, but alternative lengths of time could be used.

As the microprocessor 10 receives pulses from both the pulse initiator 12 and clock 14, it performs various temporary calculations during the data record formulation process. These calculations are performed by the microprocessor 10 in conjunction with random access memory (RAM) that is used for temporary storage. In Figure 1, this temporary storage RAM is indicated by reference numeral 16. Although both the temporary storage RAM 16 and the data storage RAM 18 utilize CMOS technology in the preferred embodiment of the present invention, the former is referred to herein as temporary storage RAM and the latter, which is described below, is referred to herein as CMOS RAM.

As data records are formulated by the microprocessor 10, the historical information contained therein is stored in complementary metal oxide semiconductor (CMOS) RAM 18. It should be understood that the temporary storage RAM 16 is significantly smaller in capacity than the CMOS RAM 18 that is used for data storage. More particularly, the temporary storage RAM typically has a capacity of approximately 1K bytes wherein the CMOS RAM would typically have a memory capacity of 64K bytes or more. Functionally, the temporary storage RAM 16 provides the microprocessor 10 with working memory that is used for the purposes of formulating the data records by accumulating both consumption related pulses from the pulse initiator 12 and time related pulses from the clock 14. The CMOS RAM 18, on the other hand, is used to accumulate a large number of records for a longer period of time. The memory capacity of the CMOS RAM 18 is used to store data records for the entire billing period which could be a month or more in duration. The RAM 16, in a preferred embodiment of the present invention is type HMG11GLPI which is available in commercial quantities from Hitachi and the CMOS RAM 18 is type HMG11GLPI (3 components) which is available from Hitachi.

The temporary storage RAM 16, CMOS RAM 18 and the clock 14 are provided with a backup battery 20. The purpose of the backup battery 20 is to provide power during periods when alternating current power is unavailable. The presence of the backup battery 20 permits the microprocessor 10 to continue to formulate data records during periods of time when electrical power is otherwise unavailable. The battery 20 used in a preferred embodiment of the present invention is type 41B020AD00701 which is available from General Electric. This particular battery is an "AA", type G.T. nickel-cadmium rechargeable battery with three cells.

A program store read only memory (ROM) 22 is provided to store the control programs used by the microprocessor 10. The ROM 22 used in a preferred embodiment of the present invention is type AM27256 which is available from Advanced Microdevices, Inc. The present invention can operate with many different types of programming systems and should not be considered to be limited to any particular software system. The actual programs used in a mass data acquisition system made in accordance with the present invention will be determined by the particular format of the data records, the actual length of time used during the formulation of a single data record, the number of meters (e.g. M1-M4) used with the system and other variables which are unrelated to the preferred embodiment of the present invention.

The present invention is also provided with miscellaneous I/O 24 which permits the microprocessor 10 to communicate with both an operator and with external devices. The miscellaneous I/O 24 would be used to provide input switches, pushbuttons and signal lights along with other signals used during the operation of the mass data acquisition system. The exact configuration of the miscellaneous I/O 24 will depend on the specific design of the mass data acquisition system with which it is used.

The microprocessor 10 of the present invention is connected in signal communication with a cartridge interface 26 for the purposes of allowing the microprocessor 10 to transmit information to a removable memory means, such as an EEPROM cartridge 28. The cartridge interface 26 can be of any configuration that enables the microprocessor 10 to read and write data in conjunction with the EEPROM cartridge 28. A typical memory cartridge that can be used in conjunction with the present invention is described in detail in U.S. Patent Application No. _____ (W.E. Case 52,522 filed on February 28, 1985). The memory cartridge 28 is removably connected to the cartridge interface 26 and can be physically transported, as indicated by arrows 30, to a translator 32 which is located at a remote location. The translator 32 is a computer based system that is designed to receive the cartridge 28 and read the data stored therein. The translator 32 is configured to read the data records, analyze them and provide reports relating to the energy consumption history of an electrical energy consumer. In a typical installation, a plurality of electrical consumers would each be provided with a mass data acquisition recorder and the electric utility would maintain a single translator 32 which could read and analyze data from a plurality of recorders. The memory cartridge 28 is used to physically transport the data from the recorders to the translator 32.

The microprocessor 10 is also provided with a serial I/O device 34 which, in conjunction with a modulator/demodulator (MODEM) 36 provides telephone communication between the mass data acquisition system of the

0196838

present invention and the translator 32. In Figure 1, this telephone communication line is indicated by arrows 38.

The present invention provides multiple alternative modes of operation. These modes of operation will be described below and should be understood to provide procedural choices for both the electric utility and electrical energy consumer.

The first mode of operation relates to a procedure in which all data is stored in the CMOS RAM 18 and no cartridge 28 is present in the cartridge interface 26 during the recording period. The microprocessor 10 would continue to receive pulses from the pulse initiator 12 and the clock 14 and would formulate data records for storage in the CMOS RAM 18. At the end of a recording period, an operator would travel to the cartridge interface 26 and insert a cartridge 28 in signal communication with both the cartridge interface 26 and the microprocessor 10. By depressing appropriate buttons or switches, the operator would request a transfer of all CMOS RAM data to the cartridge 28. In response, the microprocessor 10 would copy all of the contents of the CMOS RAM 18 into the cartridge 28. When this procedure is completed, the operator would remove the cartridge 28 from the cartridge interface 26 and physically transport it to a translator 32 for purposes of data analysis. After the microprocessor 18 transfers its data from CMOS RAM 18 to the cartridge 28, it would continue to accumulate subsequent data in the CMOS RAM 18 until again requested to transfer its contents to the cartridge 28. Under this mode of operation, referred to herein as the "RAM mode", the electric utility can utilize a relatively small number of cartridges 28 for the purposes of gathering stored data and transporting it to the translator 32. In an extreme application of this mode of operation, a single cartridge 28 can be used to service a large number of mass data acquisition systems, or recorders.

In another mode of operation, referred to herein as the "cartridge mode", a cartridge 28 would be placed in signal communication with both the cartridge interface 26 and the microprocessor 10. Upon the formulation of each data record by the microprocessor 10, the data record would be written into the CMOS RAM 18 and the cartridge 28. This redundancy provides a backup storage system that could be utilized if either the CMOS RAM 18 or the cartridge interface 26 malfunctions. When operating in the cartridge mode, the mass data acquisition system of the present invention provides two complete copies of all of the data records formulated by the microprocessor 10. At the end of the recording period, an operator would travel to the mass data acquisition system, or recorder, and remove the cartridge 28 from the cartridge interface 26. Typically, a new cartridge 28 would be placed in signal communication with the cartridge interface 26 to replace the removed cartridge 28. The present invention would continue to operate in the cartridge mode and write each subsequently formulated data record into both the CMOS RAM 18 and the cartridge 28. Meanwhile, the data cartridge that was removed from the cartridge interface 26 would be physically transported to a translator 32 for data analysis. In this mode of operation, each recorder would be provided with two cartridges 28, one of which is always in place in signal communication with the cartridge interface 26. Although this mode of operation does not significantly reduce the number of cartridges 28 required by the system, it provides a complete redundancy of data storage and prevents any possible loss of electrical energy consumption information.

A third alternative mode of operation relates to the use of the serial I/O 34 and MODEM 36 in conjunction with a telephone communication system between the mass data acquisition system and the translator 32. When the total telephone communication system is provided in conjunction with the present invention, a translator 32 has the option of calling the recorder and, by communication with the

14          **0196838**

microprocessor 10, requesting a transfer of data from the mass data acquisition system recorder to the translator 32 on the phone line. In a preferred embodiment of the present invention, the microprocessor 10 would first interrogate the cartridge 28 in order to determine that all data was properly recorded in its EEPROM memory. That data would then be read from the cartridge 28 and transmitted on the telephone line to the translator 32 for analysis. If, for any reason, the microprocessor 10 determines that the data in the cartridge 28 had been incorrectly recorded due to a malfunction of any kind, it would read the stored data from CMOS RAM 18 and transmit that data to the translator 32. Since the cartridge 28 and the CMOS RAM 18 contain identical sets of data records, this redundancy permits the CMOS RAM 18 to be used as a backup storage medium for the recorder. Of course, it should be understood that the use of the MODEM 36 and telephone lines is possible even without the presence of a data cartridge 28. If the recorder is operating in the RAM mode (i.e., no cartridge 28 present in the cartridge interface 26), data would be read from the CMOS RAM 18 by the microprocessor 10 and transmitted by the MODEM 36 to the translator 32. Therefore, it should be understood that the present invention could be used to transmit information on the telephone line in either the RAM mode or the cartridge mode.

The advantages of the present invention are realized because it utilizes a large CMOS RAM 18 that has the capacity to store the data records for an entire recording period whether or not a cartridge 28 is present in the cartridge interface 26.

It should be understood that the RAM 16 and the CMOS RAM 18 provide two completely different functions for the mass data acquisition system of the present invention. The use of RAM 16 for purposes of temporary storage during formulation of data records is known to those skilled in the art. However, it should be understood that without some other type of storage medium, such as a tape cartridge or a solid state memory cartridge, the temporary storage RAM 16 is incapable of storing the data records for a complete recording period, such as a month of consumption. This distinction is not merely related to size, but also to function. The RAM 16 in known recorders is not intended for long term storage, but for use during temporary calculations and data formulation procedures that are performed by the microprocessor 10. The CMOS RAM 18 is intended for mass data storage. Therefore, the CMOS RAM 18 differs from the RAM 16 in both size and function. Its increased size permits it to store all of the data records formulated during an entire recording period or longer. The use of a cartridge interface 26 and memory cartridge 28 provide significant advantage for both the electric utility and the electrical energy consumer. It provides a backup for the CMOS RAM 18 and provides a convenient means for physically transporting data from the recorder to a translator 32. The combination of both CMOS RAM 18 and a memory cartridge interface 26 permit the user to operate in either of two distinct modes. When operated in the RAM mode, the cartridge 28 is used only for purposes of physically transporting data from the recorder to the translator 32. When operated in the cartridge mode, the present invention provides a backup memory storage system to prevent loss of data and also permits physical transportation of recorded data to the translator 32. The present invention, when operated in the telephone communication mode, provides the option of reading data from either the cartridge 28 or the CMOS RAM 18, depending both on the presence or absence of a memory cartridge 28 and, when a memory cartridge 28 is present, the quality of data stored therein.

The present invention provides a system which allows multiple modes of operation and a dual memory mode of operation that provides backup memory storage capability.

This copy, with reference numerals inserted, is enclosed in order to assist you in interpreting and/or translating the claims, as required.

16

CLAIMS:

1. A data recorder, characterized by comprising: means (12) for receiving a first signal representative of a predetermined quantity of a measured parameter such as electrical energy consumption; means (14) for providing a second signal representative of the passage of a predetermined period of time; means (10, 16) for formulating a record of said measured parameter as a function of time, said formulating means being configured to sum a plurality of said first signals over a preselected length of time measured as a function of said second signal; first memory means (18) for storing a plurality of said records, said first memory means being connected in signal communication with said formulating means; means (26), connected in signal communication with said formulating means, for connecting a removable second memory means (28) in signal communication with said formulating means; and means (36) for transmitting messages to a remote device (34), said transmitting means being connected (34) in signal communication with said formulating device.

2. The recorder as claimed in claim 1, wherein: said first receiving means comprises a pulse generator connectable to an electric meter (M1-M4).

3. The recorder as claimed in claim 1 or 2, wherein: said formulating means comprises a microprocessor.

4.    The recorder as claimed in claim 1, 2 or 3 wherein:  said first memory means comprises random access memory.

5.    The recorder as claimed in any one of claims 1 to 4, wherein:  said second memory means is a cartridge comprising electrically erasable programmable read only memory.

6.    The recorder as claimed in claim 1 or 6 wherein:  said electrically erasable programmable read only memory is contained within a portable cartridge.

7.    The recorder as claimed in claim 1 or 5, wherein said transmitting means is within a modulator/demodulator modem and said transmitting means is connected in signal communication over a telephone communication system.

8.    A mass data acquisition system, comprising: first receiving means (12) for providing a first signal representing measured data; means (14) for providing timing pulses, each of said timing pulses representing a predetermined length of time; means (10, 16), connected in signal communication with both said first receiving and said providing means, for formulating data records; first memory means (18) for storing a plurality of said data records, said first memory means being connected in signal communication with said formulating means; and characterized by: second means (26), connected in signal communication with said formulating means, for receiving a removable second memory means (28) for storing said plurality of data records; and means (10) for detecting the presence of said removable second memory means connected in signal communication with said second receiving means, said formulating means being responsive to said detecting means, said formulating means being configured to store said data records in said first memory means when said detecting means determines the absence of said removable second memory means and to store said data records in both said first memory means and said removable second memory means

0196838

when said detecting means determines the presence of said removable second memory means.

9. The system as claimed in claim 8, wherein: first receiving means comprises a pulse generator configured to provide a plurality of pulses with each pulse representing a predetermined quantity of electrical energy consumption.

10. A recorder, substantially as hereinbefore described with reference to and as illustrated in the accompanying drawings.